# EUROPÄISCHE PATENTSCHRIFT

(11) **EP 1 978 557 B1**
(45) Veröffentlichungstag und Bekanntmachung des Hinweises auf die Patenterteilung: **08.06.2011**
(21) Anmeldenummer: 08006196.3
(22) Anmeldetag: 29.03.2008
(51) Int. Cl.: H01L 23/48

(54) **Leistungshalbleitermodul in Druckkontaktausführung sowie Verfahren zur Herstellung desselben**
Semiconductor module in pressure contact design and method for production of the same
Module semi-conducteur de puissance de type à contact à pression et procédé de fabrication associée

(30) Priorität: 04.04.2007 DE 102007016222
(43) Veröffentlichungstag der Anmeldung: 08.10.2008
(73) Patentinhaber: SEMIKRON Elektronik GmbH & Co. KG, 90431 Nürnberg (DE)
(72) Erfinder: Steger, Jürgen, 91355 Nürnberg (DE); Ebersberger, Frank, 90518 Altdorf (DE)

(56) Entgegenhaltungen:
- EP-A1- 0 546 731
- EP-A1- 1 755 163
- DE-A1- 10 149 886
- DE-A1- 10 316 356

## Beschreibung

Leistungshalbleitermodule in Druckkontaktausführung sind in unterschiedlichen Ausführungen bekannt. Beispielsweise beschreibt die DE 103 16 356 A1 ein derartiges Leistungshalbleitermodul, das aus einer Anzahl Teilmodule besteht, die jeweils eine Grundplatte sowie ein rahmenartiges Gehäuse und Anschlusselemente für Last- und Hilfsanschlüsse aufweisen. Die einzelnen Teilmodule werden mittels eines gemeinsamen Deckels und/oder mittels die einzelnen Teilmodule fixierenden Verbindungen zu dem Leistungshalbleitermodul zusammengebaut.

Ein Leistungshalbleitermodul mit mindestens einem Substrat, auf dem sich Leistungshalbleiter-Bauelemente befinden, ist beispielsweise auch aus der DE 101 49 886 A1 bekannt. Dieses bekannte Leistungshalbleitermodul umfasst außerdem eine auf das mindestens eine Substrat einwirkende Anpressvorrichtung, die dazu dient, das/jedes Substrat im montierten Zustand an ein Kühlelement anzupressen, um die Verlustwärme der Leistungshalbleiter-Bauelemente zum Kühlelement abzuführen. Bei diesem bekannten Leistungshalbleitermodul ist die Anpresseinrichtung durch ein Modulgehäuse mit mindestens einem federelastischen Bereich gebildet.

Weitere Leistungshalbleitermodule werden in der EP 0 546 731 A1 und in der EP 1 755 163 A1 beschrieben.

Der Erfindung liegt die Aufgabe zugrunde, ein Leistungshalbleitermodul in Druckkontaktausführung, zur Anordnung auf einem Kühlbauteil, zu schaffen, das einfach aufgebaut kostengünstig herstellbar ist, sowie ein Verfahren zur Herstellung des Leistungshalbleitermoduls anzugeben.

Diese Aufgabe wird gegenständlich durch die Merkmale des Anspruches 1 gelöst, d.h. mit einem Leistungshalbleitermodul in Druckkontaktausführung, zur Anordnung auf einem Kühlbauteil.
mit zwei Substraten, die an ihrer vom Kühlbauteil abgewandten Hauptfläche Leiterbahnen und Leistungshalbleiter-Bauelemente aufweisen,
mit einem Montagegrundkörper, an dessen Unterseite die beiden Substrate positioniert angeordnet sind, und der mit Ausnehmungen ausgebildet ist, durch welche mit den Leiterbahnen der Substrate druckkontaktierende Kontaktfüße durchgeführt sind, die von gegeneinander isolierten Bandabschnitten wegstehen, mit welchen Lastanschlusselemente ausgebildet sind, die am Montagegrundkörper positioniert angeordnet sind,
mit einem formstabilen steifen Deckel, der den Montagegrundkörper positioniert allseitig überdeckt und mit dem Montagegrundkörper mittels Schnapp-Rast-Verbindungen verbunden ist, und der zum Befestigen des Leistungshalbleitermoduls am Kühlbauteil mit Befestigungslöchern ausgebildet ist, und
mit zwei elastischen Kissenelementen, die zwischen dem Deckel und den Bandabschnitten der Lastanschlusselemente eingezwängt sind.

Dabei hat es sich als vorteilhaft erwiesen, wenn der Montagegrundkörper an seiner Unterseite zur genauen Positionierung der beiden Substrate zwei umlaufende Rahmenstege aufweist. Dabei besitzen die umlaufenden Rahmenstege lichte Innenabmessungen, die an die Außenrandabmessungen der Substrate angepasst sind.

Vorteilhaft ist es, wenn der Montagegrundkörper an seiner Unterseite die Ausnehmungen für die Kontaktfüße umschließende Schachterhebungen aufweist. Diese Schachterhebungen bilden für die Kontaktfüße der Lastanschlüsse in vorteilhafter Weise Führungen, durch welche die Positionierung der Kontaktfüße in Bezug auf die Leiterbahnen der Substrate optimiert ist.

Erfindungsgemäß kann der Montagegrundkörper oberseitig einen umlaufenden Rahmenrand aufweisen, von dem federnde Rastfinger wegstehen, und der Deckel ist dann vorzugsweise mit Rastlöchern für die Rastfinger ausgebildet. Die Rastfinger des Montagegrundkörpers und die Rastlöcher des Deckels bilden die Schnapp-Rast-Verbindungen zwischen dem Montagegrundkörper und dem Deckel.

Bei dem erfindungsgemäßen Leistungshalbleitermodul hat es sich als vorteilhaft erwiesen, wenn der Montagegrundkörper oberseitig mit Podesten für die Lastanschlusselemente und der Deckel mit an die Podeste angepassten Schächten ausgebildet ist. Durch eine derartige Ausbildung ergibt sich der Vorteil, dass der Deckel auf dem mit den Lastanschlusselementen - und mit Hilfsanschlusselementen - bestückten Montagegrundkörper einfach und zeitsparend genau positioniert angeordnet werden kann. Vor der Verbindung des Deckels mit dem Montagegrundkörper werden jedoch auf den Bandabschnitten der Lastanschlusselementen die Kissenelemente angeordnet.

In die Podeste des Montagegrundkörpers sind vorzugsweise Gewindehülsen integriert, die mit Durchgangslöchern axial fluchten, die an Anschlusskontakten der Lastanschlusselemente ausgebildet sind. Diese Anschlusskontakte sind durch die im Deckel ausgebildeten und an die Podeste angepassten Schächte von außen zugänglich, so dass es im zusammengebauten Zustand des erfindungsgemäßen Leistungshalbleitermoduls - nach der Befestigung desselben an einem Kühlbauteil - möglich ist, an den Anschlusskontakten Anschlusskabel oder dergleichen anzuschließen, d.h. festzuschrauben.

Der Deckel ist zweckmäßigerweise zum zusätzlichen Befestigen des Leistungshalbleitermoduls am Kühlbauteil derartig ausgebildet, dass er zwischen zwei Schächten einen Befestigungsschacht mit einem Befestigungsloch aufweist.

Bei dem Deckel des erfindungsgemäßen Leistungshalbleitermoduls handelt es sich in vorteilhafter Weise um einen aus einem geeigneten Kunststoffmaterial spritzgegossenen Deckel, der zur Erzielung der gewünschten Steifigkeit und Formstabilität an seiner Oberseite vorzugsweise mit Versteifungsrippen ausgebildet ist. Dabei sind die Versteifungsrippen vorzugsweise derartig gestaltet, dass der Deckel an seiner Oberseite mit Aufnahmeabteilen für Kondensatoren ausgebildet ist.

Bevorzugt ist es bei dem erfindungsgemäßen Leistungshalbleitermodul, wenn die Substrate mittels federnder, am Montagegrundkörper positionierter Hilfsanschlusselemente mit einer Schaltungsplatine druckkontaktiert sind, die am Deckel angebracht ist und von der Hilfskontakte wegstehen. Dabei ist es bevorzugt, wenn der Deckel mit Hilfsschächten für die Hilfskontakte ausgebildet ist. Desgleichen ist es bei einer solchen Ausbildung bevorzugt, wenn der Montagegrundkörper mit Hilfspodesten für die Hilfsschächte ausgebildet ist, in die Gewindehülsen integriert sind, die mit in den Hilfsanschlusselementen ausgebildeten Löchern axial fluchten.

Die der Erfindung zugrunde liegende Aufgabe wird verfahrensgemäß dadurch gelöst, dass zuerst die gegeneinander isolierten Lastanschlusselemente am Montagegrundkörper angeordnet werden, wobei die Kontaktfüße der Lastanschlusselemente durch die im Montagegrundkörper ausgebildeten Ausnehmungen durchgesteckt werden, so dass die Kontaktfüße unterseitig aus dem Montagegrundkörper vorstehen, dass anschließend auf den Bandabschnitten der Lastanschlusselemente die Kissenelemente angeordnet werden, zuvor oder danach am Montagegrundkörper federnde Hilfsanschlusselemente positioniert werden, dass anschließend am Montagegrundkörper der Deckel angebracht und mittels der Schnapp-Rast-Verbindungen mit dem Montagegrundkörper verbunden wird, und dass abschließend an der Unterseite des Montagegrundkörpers die mit einer Isolierstoffschicht beschichteten Substrate mittels der Isolierstoffschicht befestigt werden. Bei dieser Isolierstoffschicht handelt es sich beispielsweise um ein Silikongel, das mittels eines bekannten Beschichtungsverfahrens auf das jeweilige Substrat aufgebracht wird. Dadurch ergibt sich eine wirkungsvolle innere Isolierung des Leistungshalbleitermoduls.

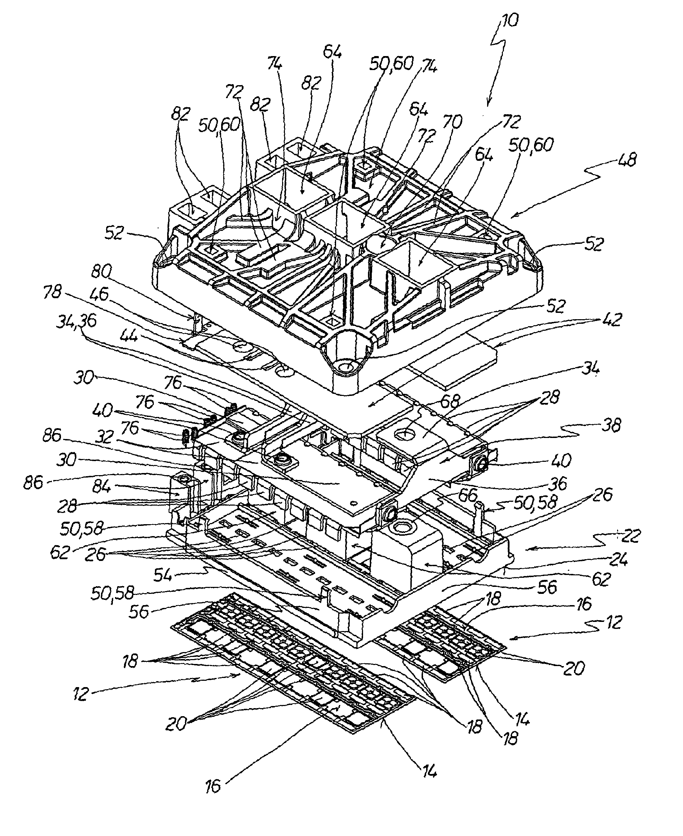

Weitere Einzelheiten, Merkmale und Vorteile ergeben sich aus der nachfolgenden Beschreibung eines in der Zeichnung dargestellten Ausführungsbeispieles des erfindungsgemäßen Leistungshalbleitermoduls.

Die Figur zeigt in einer räumlichen Explosionsdarstellung eine Ausführungsform des Leistungshalbleitermoduls 10 in Druckkontaktausführung. Das Leistungshalbleitermodul 10 weist zwei Substrate 12 auf. Jedes Substrat 12 weist an seiner Unterseite 14 eine großflächige Metallisierung auf, um zu einem (nicht dargestellten) Kühlbauteil, auf dem das Leistungshalbleitermodul 10 angeordnet wird, eine optimale Wärmeableitung zu bewirken. An der Oberseite 16 ist das jeweilige Substrat 12 mit Leiterbahnen 18 und mit Leistungshalbleiter-Bauelementen 20 versehen, die mit den Leiterbahnen 18 beispielsweise mittels (nicht gezeichneter) Bonddrähte kontaktiert sind.

Das Leistungshalbleitermodul 10 weist einen Montagegrundkörper 22 auf, an dessen Unterseite 24 die beiden Substrate 12 genau positioniert angeordnet sind. Der Montagegrundkörper 22 ist mit Ausnehmungen 26 ausgebildet, die zum Durchführen von mit den Leiterbahnen 18 der Substrate 12 druckkontaktierenden Kontaktfüßen 28 vorgesehen sind. Die Kontaktfüße 28 stehen von Bandabschnitten 30 weg, die gegeneinander mittels lsolierstoffzwischenlagen 32 elektrisch isoliert sind. Die Bandabschnitte 30 mit den Kontaktfüßen 28 bilden gemeinsam mit jeweils zugehörigen Anschlusskontakten 34, von welchen in der Zeichnungsfigur nur ein Anschlusskontakt 34 sichtbar ist, während von den anderen beiden Anschlusskontakten 34 nur ihre Verbindungsabschnitte 36 sichtbar sind, die Lastanschlusselemente 38 des Leistungshalbleitermoduls 10. Die Verbindungsabschnitte 36 der Lastanschlusselemente 38 sind mit den zugehörigen Bandabschnitten 30 mittels Nieten 40 fest verbunden.

Auf den Bandabschnitten 30 der Lastanschlusselemente 38 sind Kissenelemente 42 angeordnet, die mit den Verbindungsabschnitten 36 entsprechenden Aussparungen 44 und den Nieten 40 entsprechenden Löchern 46 ausgebildet sind.

Das Leistungshalbleitermodul 10 weist einen Deckel 48 auf, der den mit den Lastanschlusselementen 38 bestückten Montagegrundkörper 22 genau positioniert allseitig überdeckt und der mit dem Montagegrundkörper 22 mittels Schnapp-Rast-Verbindungen 50 verbunden ist.

An seinen vier Ecken ist der Deckel 48 mit Befestigungslöchern 52 ausgebildet, die zum Befestigen, d.h. Festschrauben, des Leistungshalbleitermoduls 10 an einem (nicht gezeichneten) Kühlbauteil dienen.

Zur genauen Positionierung der beiden Substrate 12 an der Unterseite 24 des Montagegrundkörpers 22 ist dieser an seiner Unterseite 24 mit zwei in sich geschlossen umlaufenden Rahmenstegen 54 ausgebildet. Der Montagekörper 22 weist oberseitig einen umlaufenden Rahmenrand 56 auf, von dem federnde Rastfinger 58 wegstehen. Der Deckel 48 ist mit Rastlöchern 60 ausgebildet, die mit den Rastfingern 58 die Schnapp-Rast-Verbindungen 50 bilden.

Von der Oberseite des Montagegrundkörpers 22 stehen materialeinstückig Podeste 62 weg, die zur Zentrierung und genauen Positionierung der Lastanschlusselemente 38 und außerdem zur zentrierten Positionierung des Deckels 48 vorgesehen sind. Zu diesem Zwecke ist der Deckel 48 mit an die Podeste 62 angepassten Schächten 64 ausgebildet.

In die Podeste 62 sind Gewindehülsen 66 integriert. Die Gewindehülsen 66 fluchten mit Durchgangslöchern 68, die in den Anschlusskontakten 34 der Lastanschlusselemente 38 ausgebildet sind.

Zwischen zwei Schächten 64, d.h. in der Zeichnung zwischen dem rechten und dem mittleren Schacht 64, ist im Deckel 48 ein Befestigungsschacht 70 ausgebildet, der ein (nicht dargestelltes) Befestigungsloch aufweist. Dadurch ist eine zusätzliche Befestigung des Leistungshalbleitermoduls 10 an dem (nicht dargestellten) Kühlbauteil möglich.

Der Deckel 48 ist an seiner Oberseite mit Versteifungsrippen 72 ausgebildet. Die Versteifungsrippen 72 sind derartig gestaltet, dass der Deckel 48 an seiner Oberseite Aufnahmeabteile 74 für (nicht dargestellte) Kondensatoren aufweist.

Die Substrate 12 sind mittels federnder, am Montagegrundkörper 22 positionierter Hilfsanschlusselemente 76 mit einer Schaltungsplatine 78 druckkontaktiert, die am Deckel 48 innenseitig befestigt ist und von der Hilfskontakte 80 wegstehen. Der Deckel 48 ist mit Hilfsschächten 82 ausgebildet, die für die Hilfskontakte 80 vorgesehen sind. Der Montagegrundkörper 22 ist mit an die Hilfsschächte 82 angepassten Hilfspodesten 84 ausgebildet, in die Gewindehülsen 86 integriert sind, die mit in der Zeichnungsfigur nicht sichtbaren Löchern der Hilfsanschlusselemente 80 im zusammengebauten Zustand des Leistungshalbleitermoduls 10 axial fluchten.

### Bezugsziffernliste

- 10: Leistungshalbleitermodul
- 12: Substrate (von 10)
- 14: Unterseite (von 12)
- 16: Oberseite (von 12)
- 18: Leiterbahnen (an 16 für 20)
- 20: Leistungshalbleiter-Bauelemente (an 16)
- 22: Montagegrundkörper (von 10 für 38)
- 24: Unterseite (von 22 für 12)
- 26: Ausnehmungen (in 22 für 28)
- 28: Kontaktfüße (an 30)
- 30: Bandabschnitte (von 38)
- 32: lsolierstoffzwischenlagen (zwischen 30 und 30)
- 34: Anschlusskontakte (an 30)
- 36: Verbindungsabschnitte (von 34)
- 38: Lastanschlusselemente (von 10)
- 40: Nieten (zwischen 30 und 36)
- 42: Kissenelemente (zwischen 30 und 48)
- 44: Aussparungen (in 42 für 36)
- 46: Löcher (in 42 für 40)
- 48: Deckel (von 10)
- 50: Schnapp-Rast-Verbindungen (zwischen 22 und 48)
- 52: Befestigungslöcher (von 50 in 48)
- 54: Rahmensteg (an 24 von 22)
- 56: Rahmenrand (von 22)
- 58: Rastfinger (von 50 in 48)
- 62: Podeste (von 22 für 38)
- 64: Schächte (in 48 für 62)
- 66: Gewindehülse (in 62)
- 68: Durchgangsloch (in 34)
- 70: Befestigungsschacht (in 48)
- 72: Versteifungsrippen (von 48)
- 74: Aufnahmeabteile (von 48)
- 76: Hilfsanschlusselemente (von 10)
- 78: Schaltungsplatine (für 76 in 48)
- 80: Hilfskontakte (an 78)
- 82: Hilfsschächte (von 48 für 80)
- 84: Hilfspodeste (von 22 für 82)
- 86: Gewindehülse (in 84)

## Patentansprüche

1. Leistungshalbleitermodul in Druckkontaktausführung, zur Anordnung auf einem Kühlkörper
mit zwei Substraten (12), die an ihrer vom Kühlbauteil abgewandten Oberseite (16) Leiterbahnen und Leistungshalbleiter-Bauelemente (20) aufweisen,
mit einem Montagegrundkörper (22), an dessen Unterseite (24) die beiden Substrate (12) positioniert angeordnet sind, und der mit Ausnehmungen (26) ausgebildet ist, durch welche mit den Leiterbahnen (18) der Substrate (12) druckkontaktierende Kontaktfüße (28) durchgeführt sind, die von gegeneinander isolierten Bandabschnitten (30) wegstehen, mit welchen Lastanschlusselemente (38) ausgebildet sind, die am Montagegrundkörper (22) positioniert angeordnet sind,
mit einem formstabilen steifen Deckel (48), der den Montagegrundkörper (22) positioniert allseitig überdeckt und mit dem Montagegrundkörper (22) mittels Schnapp-Rast-Verbindungen (58. 60) verbunden ist, und der zum Befestigen des Leistungshalbleitermoduls (10) am Kühlbauteil mit Befestigungslöchern (52) ausgebildet ist, und
mit zwei elastischen Kissenelementen (42), die zwischen dem Deckel (48) und den Bandabschnitten (30) der Lastanschlusselemente (48) eingezwängt sind.

2. Leistungshalbleitermodul nach Anspruch 1,
**dadurch gekennzeichnet,**
**dass** der Montagegrundkörper (22) an seiner Unterseite (24) zur genauen Positionierung der beiden Substrate (12) zwei umlaufende Rahmenstege (54) aufweist.

3. Leistungshalbleitermodul nach Anspruch 1,
**dadurch gekennzeichnet,**
**dass** der Montagegrundkörper (22) an seiner Unterseite (24) die Ausnehmungen (26) für die Kontaktfüße (28) umschließende Schachterhebungen aufweist.

4. Leistungshalbleitermodul nach Anspruch 1,
**dadurch gekennzeichnet,**
**dass** der Montagegrundkörper (22) oberseitig einen umlaufenden Rahmenrand (56) aufweist, von dem federnde Rastfinger (58) der Schnapp-Rast-Verbindungen wegstehen, und dass der Deckel (48) mit Rastlöchern (60) für die Rastfinger (58) ausgebildet ist.

5. Leistungshalbleitermodul nach Anspruch 1,
**dadurch gekennzeichnet,**
**dass** der Montagegrundkörper (22) oberseitig mit Podesten (62) für die Lastanschlusselemente (38) und der Deckel (48) mit an die Podeste (62) angepassten Schächten (64) ausgebildet ist.

6. Leistungshalbleitermodul nach Anspruch 5,
**dadurch gekennzeichnet,**
**dass** in die Podeste (62) Gewindehülsen (66) integriert sind, die mit Durchgangslöchern (68) axial fluchten, die in Anschlusskontakten (34) der Lastanschlusselemente (38) ausgebildet sind.

7. Leistungshalbleitermodul nach Anspruch 1,
**dadurch gekennzeichnet,**
**dass** der Deckel (48) zum zusätzlichen Befestigen des Leistungshalbleitermoduls (10) am Kühlbauteil zwischen zwei Schächten (64) einen Befestigungsschacht (70) mit einem Befestigungsloch aufweist.

8. Leistungshalbleitermodul nach einem der Ansprüche 1 bis 7,
**dadurch gekennzeichnet,**
**dass** der Deckel (48) an seiner Oberseite mit Versteifungsrippen (72) ausgebildet ist.

9. Leistungshalbleitermodul nach einem der Ansprüche 1 bis 8,
**dadurch gekennzeichnet,**
**dass** der Deckel (48) an seiner Oberseite mit Aufnahmeabteilen (74) für elektrische Kondensatoren ausgebildet ist.

10. Leistungshalbleitermodul nach einem der Ansprüche 1 bis 9,
**dadurch gekennzeichnet,**
**dass** die Substrate (12) mittels federnder, am Montagegrundkörper (22) positionierter Hilfsanschlusselemente (76) mit einer Schaltungsplatine (78) druckkontaktiert sind, die am Deckel (48) angebracht ist und von der Hilfskontakte (80) wegstehen.

11. Leistungshalbleitermodul nach Anspruch 10,
**dadurch gekennzeichnet,**
**dass** der Deckel (48) mit Hilfsschächten (82) für die Hilfskontakte(80) ausgebildet ist.

12. Leistungshalbleitermodul nach Anspruch 10,
**dadurch gekennzeichnet,**
**dass** der Montagegrundkörper (22) mit Hilfspodesten (84) ausgebildet ist, in die Gewindehülsen (86) integriert sind, die mit in den Hilfsanschlusselementen (80) ausgebildeten Löchern axial fluchten.

13. Verfahren zur Herstellung eines Leistungshalbleitermodul nach einem der vorhergehenden Ansprüche, wobei zuerst die gegeneinander elektrisch isolierten Lastanschlusselemente (38) am Montagegrundkörper (22) angeordnet werden, wobei die Kontaktfüße (28) der Lastanschlusselemente (38) durch die im Montagegrundkörper (22) ausgebildeten Ausnehmungen (26) durchgesteckt werden, so dass die Kontaktfüße unterseitig aus dem Montagegrundkörper (22) vorstehen, anschließend auf den Bandabschnitten (30) der Lastanschlusselemente (38) die Kissenelemente (42) angeordnet werden, zuvor oder danach am Montagegrundkörper (22) federnde Hilfsanschlusselemente (76) positioniert werden, anschließend am Montagegrundkörper (22) der Deckel (48) angebracht und mittels der Schnapp-Rast-Verbindungen (50) mit dem Montagegrundkörper (22() verbunden wird, und abschließend an der Unterseite (24) des Montagegrundkörpers (22) die mit einer Isolierstoffschicht beschichteten Substrate (12) mittels der Isolierstoffschicht befestigt werden.

## Claims

1. A power semiconductor module in pressure contact design, for arrangement on a heat sink
having two substrates (12), which comprise conductor tracks and semiconductor components (20) on their top surface (16) facing away from the heatsink,
having a base plate (22), on the underside (24) of which the two substrates (12) are positioned, and which is designed with recesses (26) through which contact feet (28) in pressure contact with the conductor tracks (18) of the substrates (12) are passed, which protrude from band sections (30) insulated from one another, with which load connection elements (38) positioned on the base plate (22) are constructed,
having a dimensionally stable stiff cover (48), which in position covers the base plate (22) on all sides and is connected to the base plate (22) by means of snap-lock connections (58, 60), and which is designed for fixing the power semiconductor module (10) on the heatsink with fixing holes (52), and
having two elastic cushioning elements (42), which are forced in between the cover (48) and the band sections (30) of the load connection elements (48).

2. The power semiconductor module according to Claim 1,
**characterized in that**
the base plate (22) comprises two circumferential frame sections (54) on its underside (24) for precise positioning of the two substrates (12).

3. The power semiconductor module according to Claim 1,
**characterized in that**
the base plate (22) comprises the recesses (26) for the channel projections enclosing the contact feet (28) on its underside (24).

4. The power semiconductor module according to Claim 1,
**characterized in that**
the base plate (22) comprises a circumferential frame edge (56) on its top surface, from which elastic locking fingers (58) of the snap-lock connections protrude, and that the cover (48) is designed with locking holes (60) for the locking fingers (58).

5. The power semiconductor module according to Claim 1,
**characterized in that**
on its upper surface the base plate (22) is designed with platforms (62) for the load connection elements (38) and the cover (48) is designed with channels (64) that are matched to the platforms (62).

6. The power semiconductor module according to Claim 5,
**characterized in that**
threaded sleeves (66) are integrated into the platforms (62), which are axially flush with through holes (68) constructed in terminal contacts (34) of the load connection elements (38).

7. The power semiconductor module according to Claim 1,
**characterized in that**
to provide additional fixing of the power semiconductor module (10) on the heatsink, the cover (48) comprises a fixing channel (70) with a fixing hole between two channels (64).

8. The power semiconductor module according to one of Claims 1 to 7,
**characterized in that**
the cover (48) is designed with stiffening ribs (72) on its upper surface.

9. The power semiconductor module according to one of Claims 1 to 8,
**characterized in that**
the cover (48) is designed with retaining compartments (74) for electrical capacitors on its upper surface.

10. The power semiconductor module according to one of Claims 1 to 9,
**characterized in that**
the substrates (12) are pressure contacted by means of elastic auxiliary connection elements (76) positioned on the base plate (22) to a circuit board (78), which is placed on the cover (48) and from which auxiliary contacts (80) protrude.

11. The power semiconductor module according to Claim 10,
**characterized in that**
the cover (48) is designed with auxiliary channels (82) for the auxiliary contacts (80).

12. The power semiconductor module according to Claim 10,
**characterized in that**
the base plate (22) is designed with auxiliary platforms (84), into which threaded sleeves (86) are integrated, which are axially flush with holes formed in the auxiliary connection elements (80).

13. Method for producing a power semiconductor module according to one of the preceding claims, wherein firstly the load connection elements (38) insulated from one another are arranged on the base plate (22), wherein the contact feet (28) of the load connection elements (38) are pushed through the recesses (26) constructed in the base plate (22), so that the contact feet protrude from the underside of the base plate (22), the cushioning elements (42) are then arranged on the band sections (30) of the load connection elements (38), before or after which elastic auxiliary contact elements (76) are positioned on the base plate (22), the cover (48) is then placed on the base plate (22) and connected to the base plate (22) by means of the snap-lock connections (50), and finally the substrates (12) coated with an insulator layer are fixed onto the underside (24) of the base plate (22) by means of the insulator layer.

## Revendications

1. Module à semi-conducteurs de puissance dans une version de contact de pression, destiné à être disposé sur un corps réfrigérant
comprenant deux substrats (12), qui présentent des pistes conductrices et des composants à semi-conducteurs de puissance (20) sur leur côté supérieur (16) opposé au composant réfrigérant,
un corps de base de montage (22), sur la face inférieure (24) duquel les deux substrats (12) sont positionnés, et qui est doté d'évidements (26), à travers lesquels sont guidés des pieds de contact (28) établissant un contact de pression avec les pistes conductrices (18) des substrats (12), lesquels pieds partent de parties de bande (30) isolées les unes par rapport aux autres, avec lesquelles des éléments de raccordement de charge (38) sont conçus, qui sont disposés sur le corps de base de montage (22),
un couvercle (48) rigide et indéformable qui recouvre sur tous les côtés le corps de base de montage (22) de façon positionnée et est relié avec le corps de base de montage (22) au moyen de liaisons à verrouillage et encliquetage (58, 60), et qui est conçu avec des trous de fixation (52) pour la fixation du module à semi-conducteurs de puissance (10) sur le composant réfrigérant, et
deux éléments de coussin (42) élastiques, qui sont introduits par force entre le couvercle (48) et les parties de bande (30) des éléments de raccordement de charge (48).

2. Module à semi-conducteurs de puissance selon la revendication 1,
**caractérisé en ce que**
le corps de base de montage (22) présente deux barrettes de cadre (54) périphériques sur son côté inférieur (24) pour le positionnement précis des deux substrats (12).

3. Module à semi-conducteurs de puissance selon la revendication 1,
**caractérisé en ce que**
le corps de base de montage (22) présente sur son côté inférieur (24) les élévations de goulotte entourant les évidements (26) pour les pieds de contact (28).

4. Module à semi-conducteurs de puissance selon la revendication 1,
**caractérisé en ce que**
le corps de base de montage (22) présente côté supérieur un bord de cadre (56) périphérique, duquel partent des doigts d'encliquetage (58) élastiques des liaisons à verrouillage et encliquetage, et **en ce que** le couvercle (48) est conçu avec des trous d'encliquetage (60) pour les doigts d'encliquetage (58).

5. Module à semi-conducteurs de puissance selon la revendication 1,
**caractérisé en ce que**
le corps de base de montage (22) est conçu côté supérieur avec des paliers (62) pour les éléments de raccordement de charge (38) et le couvercle (48) avec des gaines (64) adaptées aux paliers (62).

6. Module à semi-conducteurs de puissance selon la revendication 5,
**caractérisé en ce que**
des douilles filetées (66), qui sont alignées axialement avec des trous de passage (68) conçues dans des contacts de raccordement (34) des éléments de raccordement de charge (38), sont intégrées dans les paliers (62).

7. Module à semi-conducteurs de puissance selon la revendication 1,
**caractérisé en ce que**
le couvercle (48) présente une couche de fixation (70) avec un trou de fixation pour la fixation supplémentaire du module à semi-conducteurs de charge (10) sur l'élément réfrigérant entre deux gaines (64).

8. Module à semi-conducteurs de puissance selon l'une quelconque des revendications 1 à 7,
**caractérisé en ce que**
le couvercle (48) est conçu avec des nervures de renfort (72) sur son côté supérieur.

9. Module à semi-conducteurs de puissance selon l'une quelconque des revendications 1 à 8,
**caractérisé en ce que**
le couvercle (48) est doté sur son côté supérieur de compartiments de logement (74) pour des condensateurs électriques.

10. Module à semi-conducteurs de puissance selon l'une quelconque des revendications 1 à 9,
**caractérisé en ce que**
les substrats (12) sont mis en contact de pression au moyen d'éléments de raccordement auxiliaires (76) élastiques et positionnés sur le corps de base de montage (22) avec une platine de circuit (78) qui est placée sur le couvercle (48) et de laquelle partent des contacts auxiliaires (80).

11. Module à semi-conducteurs de puissance selon la revendication 10,
**caractérisé en ce que**
le couvercle (48) est conçu avec des gaines auxiliaires (82) pour les contacts auxiliaires (80).

12. Module à semi-conducteurs de puissance selon la revendication 10,
**caractérisé en ce que**
le corps de base de montage (22) est conçu avec des paliers auxiliaires (84) dans lesquels sont intégrées des douilles filetées (86), lesquelles sont alignées axialement avec les trous formés dans les éléments de raccordement auxiliaires (80).

13. Procédé pour fabriquer un module à semi-conducteurs de puissance selon l'une quelconque des revendications précédentes, les éléments de raccordement de charge (38) isolés électriquement les uns par rapport aux autres étant disposés d'abord sur le corps de base de montage (22), les pieds de contact (28) des éléments de raccordement de charge (38) étant enfichés à travers les évidements (26) conçus dans le corps de base de montage (22), de telle sorte que les pieds de contact dépassent côté inférieur du corps de base de montage (22), les éléments de coussin (42) sont disposés ensuite sur les parties de bande (30) des éléments de raccordement de charge (38), des éléments de raccordement auxiliaires (76) élastiques sont positionnés avant ou après sur le corps de base de montage (22), le couvercle (48) est placé ensuite sur le corps de base de montage (22) et est relié au corps de base de montage (22) au moyen des liaisons à encliquetage et verrouillage (50), et les substrats (12) revêtus avec une couche de matière isolante sont fixés pour finir au moyen de la couche de matière isolante sur le côté inférieur (24) du corps de base de montage (22).
